# EUROPÄISCHE PATENTSCHRIFT

(11) **EP 2 704 544 B1**
(45) Veröffentlichungstag und Bekanntmachung des Hinweises auf die Patenterteilung: **03.02.2016**
(21) Anmeldenummer: 13178922.4
(22) Anmeldetag: 01.08.2013
(51) Int. Cl.: H05K 5/06, G01P 1/02, G01D 11/24, H03K 17/95

(54) **Sensoranordnung**
Sensor assembly
Dispositif de détection

(30) Priorität: 03.09.2012 DE 102012108147
(43) Veröffentlichungstag der Anmeldung: 05.03.2014
(73) Patentinhaber: SICK AG, 79183 Waldkirch (DE)
(72) Erfinder: Freyer, Dr. Carsten, 79183 Waldkirch (DE)

(56) Entgegenhaltungen:
- DE-A1- 2 952 297
- DE-A1- 10 121 776
- DE-A1- 19 504 608
- DE-A1-102009 060 872

## Beschreibung

Eine Vielzahl von Sensoren, insbesondere Sensoren zur Detektion magnetischer Felder, werden nach dem heutigen Stand der Technik als bestückte Leiterplatte realisiert. Um eine derartige bestückte Leiterplatte vor Umwelteinflüssen und Beschädigung zu schützen, ist es eine gängige Vorgehensweise, eine Sensoranordnung zu schaffen, bei der die bestückte Leiterplatte mit der darauf angeordneten Sensorelektronik innerhalb eines Kunststoffgehäuses angeordnet ist. Etwaig vorhandene Anschlussleitungen, insbesondere elektrische Versorgungs- und Signalleitungen, mit denen die bestückte Leiterplatte kontaktiert ist, können dann durch Umspritzung mit Kunststoff stabilisiert und geschützt werden.

Ein typisches bekanntes Verfahren zur Herstellung einer derartigen Sensoranordnung besteht darin, dass die bestückte Leiterplatte in ein vorgefertigtes Gehäuse, das eine offene Seite aufweist, eingeschoben wird. Anschließend werden dann die Anschlusskabel mit einem Kunststoff, insbesondere einem Thermoplast-Material umspritzt, wobei im Regelfall der Kunststoff in das Gehäuseinnere eintritt, so dass die Elektronikkarte zumindest teilweise mit umspritzt wird.

Dies mag zwar auf den ersten Blick als vorteilhaft erscheinen, weil dadurch der Schutz vor Umwelteinflüssen scheinbar verbessert wird, man muss sich aber vergegenwärtigen, dass auch das Umspritzen selbst die bestückte Leiterplatte und insbesondere die darauf angeordneten Elektronikbauteile erheblichen Belastungen im Hinblick auf den dabei auftretenden Druck, vor allem aber auch im Hinblick auf thermische Belastungen durch die heißen Thermoplaste, mit denen umspritzt wird, aussetzt. Als Konsequenz gibt es ein Risiko, dass beim Umspritzen empfindliche Elektronikbauteile so beschädigt werden, dass ihre einwandfreie Funktion nicht mehr gewährleistet ist. Insbesondere die ordnungsgemäße Funktion von Reed-Kontakten wird bei dieser Vorgehensweise oftmals beeinträchtigt.

Um dieser Problematik entgegen zu wirken, sind aus dem Stand der Technik eine Reihe von Vorgehensweisen bekannt. Einerseits kann man auf niedrigschmelzende Thermoplaste, die unter dem Begriff "Hotmelt" bekannt sind und bei geringeren Temperaturen spritzbar sind, zurückgreifen. Diese sind aber hinsichtlich der erzielbaren Dichtheit und des realisierbaren mechanischen Schutzes üblichen Thermoplasten deutlich unterlegen.

Eine andere Strategie besteht darin, zu vermeiden, dass es zu einem Kontakt zwischen empfindlichen Elektronikbauteilen und dem gespritzten Thermoplast kommt. Allgemein werden die empfindlichsten Elektronikbauteile an dem Ende der Leiterplatte angeordnet, welches am weitesten in das Gehäuse eingeschoben wird. Eine erste Möglichkeit zur Verhinderung des Kontakts zwischen empfindlichen Elektronikbauteilen und dem gespritzten Thermoplast besteht darin, diesen Abschnitt in einem vorgeschalteten Arbeitsschritt vorab auf schonende Weise mit einem anderen geeigneten Füllmaterial zu befüllen, so dass kein geschmolzener Thermoplast mehr eindringen kann. Eine zweite Möglichkeit besteht darin, Trennwände innerhalb des Gehäuses vorzusehen. Eine dritte Alternative besteht darin, einen komplexen Spritzgussprozess durchzuführen, bei dem sichergestellt ist, dass der Füllprozess vor dem Erreichen einer vollständigen Füllung unterbrochen wird und ein Hohlraum im Gehäuse verbleibt.

All diesen Möglichkeiten ist gemein, dass sie fertigungstechnisch mit einem hohen Aufwand verbunden sind und daher die Herstellungskosten für die Sensoranordnung beträchtlich erhöhen. Ferner erweisen sie sich als unzuverlässig, weil für eine zuverlässige Umspritzung ein hoher Spritzdruck notwendig ist, weshalb es immer wieder zu ungewollter Befüllung des Hohlraums und Beschädigung der Elektronikbausteine kommt.

Die DE 10 2009 060 872 A1 offenbart einen gehäusten Sensor, sowie ein Verfahren zum Verkapseln eines Sensors in einem Gehäuse, wobei der Sensor hermetisch dicht verkapselt wird.

Die DE 29 52 297 A1 offenbart ein Verfahren zur Herstellung von elektrischen Geräten, insbesondere berührungslosen Sensoren und Modulen, deren Schaltungsbaueinheit mit Kunststoff umschäumt und von einer massiven Gehäusehülle umgeben ist.

Die DE 195 04 608 A1 offenbart einen Positionssensor, umfassend eine auf einem Träger angeordnete elektrische Schaltung, welche mit einem elektrischen Anschlusselement und mit einem Sensorelement verbunden ist, und ein Gehäuse mit einem Innenraum zur Aufnahme des Trägers mit der elektrischen Schaltung, welches eine Öffnung für das Anschlusselement und eine Öffnung für das Sensorelement aufweist, wobei Zwischenräume mit einer Duroplast-Formmasse ausgefüllt sind.

Die DE 101 21 776 A1 betrifft einen Sensor mit einer Trägerplatte, welche in einem zumindest teilweise im Spritzverfahren hergestellten Gehäuse angeordnet und mit elektronischen, optischen, elektromechanischen und/oder optoelektronischen Bauelementen bestückt ist, wobei ein Teilbereich der Trägerplatte und zumindest einige der darauf befindlichen Bauelemente in einem innerhalb des zumindest teilweise gespritzten Gehäuses ausgebildeten Hohlraum angeordnet sind.

Die Aufgabe der Erfindung besteht daher darin, eine einfach und kostengünstig herzustellende Sensoranordnung und ein Verfahren zu deren Herstellung bereitzustellen.

Diese Aufgabe wird gelöst durch eine Sensoranordnung mit den Merkmalen des Schutzanspruchs 1, sowie mit einem Verfahren zur Herstellung einer Sensoranordnung nach Anspruch 7. Vorteilhafte Weiterbildungen der Erfindung sind Gegenstand der Unteransprüche.

Die erfindungsgemäße Sensoranordnung weist eine bestückte Leiterplatte mit elektrischen Anschlüssen auf, wobei mindestes ein auf der bestückten Leiterplatte angeordnetes Elektronikbauteil oder eine Kombination von auf der bestückten Leiterplatte angeordneten Elektronikbauteilen einen Sensor bilden, und ein Gehäuse, in dessen Innenraum mindestens ein Endabschnitt der bestückten Leiterplatte angeordnet ist. Zweckmäßigerweise handelt es sich bei diesem Endabschnitt bevorzugt um den Abschnitt der bestückten Leiterplatte, auf dem die empfindlichsten und/oder die für die Sensorfunktion wesentlichen Elektronikbauteile angeordnet sind. Erfindungswesentlich ist, dass mindestens ein umgeformter Abschnitt des Gehäuses vorhanden ist, der auf der den elektrischen Anschlüssen der bestückten Leiterplatte zugewandten Seite des Gehäuses so umgeformt ist, dass er an der bestückten Leiterplatte, vorzugsweise an einem unbestückten Abschnitt der bestückten Leiterplatte, anliegt und die Sensoranordnung in einem Bereich vom umgeformten Abschnitt des Gehäuses bis zum Anschlusskabel umspritzt ist.

Durch diese Ausgestaltung der Sensoranordnung wird auf einfache Weise mit einem simplen Umformschritt ein Eindringen von Thermoplasten beim Umspritzen effektiv verhindert.

In diesem Zusammenhang wird darauf hingewiesen, dass unter elektrischen Anschlüssen nicht allein Versorgungs- und Datenleitungen zu verstehen sind, sondern auch schon Anschlussvorrichtungen für solche Leitungen, wie z.B. Klemmen oder Kontaktflächen.

Zweckmäßigerweise ist das Gehäuse hülsenartig ausgebildet, was bedeuten soll, dass zumindest auf einer Seite des Gehäuses keine Wand vorgesehen ist oder die Wand eine Öffnung oder Durchbrechung aufweist, durch die die bestückte Leiterplatte hindurchgeführt ist. Allerdings sollte das Gehäuse bevorzugt in Form einer Hülse, die auf der Seite, die der die Öffnung aufweisende Seite gegenüber liegt, abgeschlossen ist, ausgeführt sein.

Besonders bevorzugt ist es, wenn das Gehäuse aus einem thermoplastischen Material besteht, weil dann der Umformschritt besonders materialschonend und prozesssicher mit einem beheizten Umformwerkzeug durchgeführt werden kann. Dabei ist durch eine entsprechende Formgebung des Umformwerkzeugs ein optimales Profil für das Anhaften des nachfolgend angespritzten Kunststoffs auf einfache Weise erzielbar.

Besonders vorteilhaft ist es, wenn im umgeformten Abschnitt des Gehäuses der Abstand zwischen einander gegenüberliegenden Seiten des umgeformten Abschnitts des Gehäuses in Erstreckungsrichtung der bestückten Leiterplatte ausgehend von der den Anschlüssen der bestückten Leiterplatte zugewandten Seite hin zu deren im Gehäuse angeordneten Endabschnitt monoton oder streng monoton steigt. Bei dieser geometrischen Ausgestaltung wird erreicht, dass beim radialen Aufschrumpfen des zum Umspritzen verwendeten Thermoplast-Materials auftretende Kräfte die Abdichtung noch weiter verbessern. Dabei sind die Begriffe monoton steigend bzw. streng monoton steigend wie in der Mathematik üblich auszulegen.

Eine besonders einfache Ausgestaltung der Erfindung sieht vor, dass der umgeformte Abschnitt des Gehäuses einen kegelförmigen Kragen bildet.

Komplizierter, aber im Hinblick auf das Herstellen einer sicheren und belastbaren Verbindung zwischen dem Gehäuse und dem angespritzten Thermoplast-Material vorteilhafter ist es aber, wenn die Steigung des Abstands zwischen einander gegenüberliegenden Seiten des umgeformten Abschnitts des Gehäuses in Erstreckungsrichtung der bestückten Leiterplatte ausgehend von der den Anschlüssen der bestückten Leiterplatte zugewandten Seite hin zu deren im Gehäuse angeordneten Endabschnitt monoton oder streng monoton steigt. Die resultierende, relativ zu einer kegelförmigen Ausführungsgeometrie konkave Oberflächenkontur des umgeformten Abschnitts des Gehäuses bewirkt eine Oberflächenvergrößerung und verbessert das Anhaften des Thermoplast-Materials an diesem Abschnitt.

Je nach Geometrie der bestückten Leiterplatte erweist es sich als vorteilhaft, wenn der umgeformte Abschnitt des Gehäuses durch Pressen axial von oben, zwei- oder mehrteilig radial oder in einer Kombination dieser Varianten umgeformt ist.

Materialschonend kann die Umformung insbesondere dann durchgeführt werden, wenn der umgeformte Abschnitt des Gehäuses mit einem erwärmten Formwerkzeug umgeformt ist.

Als Erfindung anzusehen ist auch das Verfahren zur Herstellung einer erfindungsgemäßen Sensoranordnung. Dabei werden eine mit Elektronikbausteinen, welche insbesondere die gewünschte Sensor-Funktionalität bereitstellen, bestückte Leiterplatte mit elektrischen Anschlüssen und ein Gehäuse, bevorzugt eine Hülse, die insbesondere auf einer Stirnseite geschlossen und auf der anderen Stirnseite offen ist, bereitgestellt, wobei die räumlichen Abmessungen des Gehäuses so gewählt sind, dass ein Endabschnitt der bestückten Leiterplatte, der insbesondere die für die Sensor-Funktionalität relevanten Elektronikbausteine trägt, in den Innenraum des Gehäuses einführbar ist.

Der Endabschnitt der bestückten Leiterplatte wird dann in den Innenraum des Gehäuses eingeführt und im weiteren Verlauf der Herstellung mit einem Thermoplast-Material umspritzt. Wesentlich für das erfindungsgemäße Verfahren ist, dass nach dem Einführen und vor dem Beginn des Umspritzens an dem Gehäuse ein Umformschritt vorgenommen wird. Konkret wird dieser so ausgeführt, dass der den elektrischen Anschlüssen zugewandte Rand der Hülse so umgeformt wird, dass er an der Leiterplatte anliegt. Dadurch werden die empfindlichen Elektronikbauteile, die auf dem in den Innenraum des Gehäuses aufgenommenen Endabschnitt angeordnet sind, auf einfache und effektive Weise vor Beschädigungen beim Umspritzen geschützt, und zwar selbst dann, wenn das Umspritzen bei hohen Temperaturen und hohem Druck erfolgt.

Eine vorteilhafte Weiterbildung des Verfahrens besteht darin, ein Gehäuse aus einem Thermoplast-Material bereitzustellen und die Umformung mit einem oder mehreren beheizten Umformwerkzeugen durchzuführen.

Die Erfindung wird nachfolgend an Figuren, die spezielle Ausführungsbeispiele der Erfindung zeigen, näher erläutert. Es zeigt:
- Fig. 1:: ein erstes Zwischenstadium bei der Herstellung einer Sensoranordnung, gezeigt als Schnittdarstellung
- Fig. 2:: ein zweites Zwischenstadium bei der Herstellung einer Sensoranordnung, gezeigt als Schnittdarstellung, und
- Fig. 3:: ein Ausführungsbeispiel einer erfindungsgemäßen Sensoranordnung, gezeigt als Schnittdarstellung.

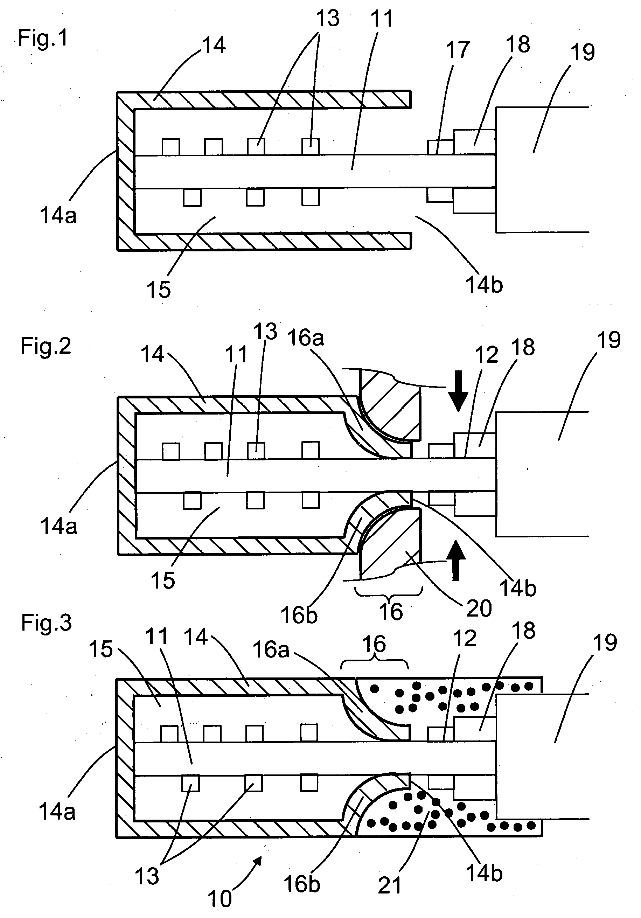

Da in den Figuren 1 bis 3 unterschiedliche Stadien bei der Herstellung derselben Ausführungsform der Erfindung dargestellt werden, werden identische Bezugszeichen verwendet.

In dem in Figur 1 gezeigten Zwischenstadium erkennt man ein Gehäuse 14 mit Innenraum 15. Das Gehäuse 14 ist hier als eine Hülse, die insbesondere auf einer Stirnseite 14a geschlossen und auf der anderen Stirnseite 14b offen ist, ausgeführt, andere Gehäuseformen sind denkbar.

Weiter erkennt man eine mit den schematisch dargestellten Elektronikbauteilen 13 bestückte Leiterplatte 11 und einem elektrischen Anschluss 17, der konkret als ebenfalls schematisch dargestellte Steckverbindung zu den Adern 18 eines Abschlusskabels 19 ausgeführt ist. Selbstverständlich sind andere Arten von Anschlüssen, insbesondere auch ein Lötkontakt zu Adern eines Anschlusskabels, ebenfalls möglich. Der mit den Elektronikbauteilen 13 bestückte Endabschnitt der bestückten Leiterplatte ist in den Innenraum 15 des Gehäuses 14 eingeführt.

Das in Figur 2 gezeigte Zwischenstadium der Herstellung unterscheidet sich von vorstehendem anhand der Figur 1 diskutierten Zwischenstadium dadurch, dass mit einem Formwerkzeug 20, das in die in Figur 2 durch Pfeile gekennzeichneten Richtungen bewegt wurde, der Abschnitt des Gehäuses 14 auf der den elektrischen Anschlüssen 12 der bestückten Leiterplatte 11 zugewandten Seite des Gehäuses 14 umgeformt wurde, so dass ein umgeformter Abschnitt 16, der an der bestückten Leiterplatte (11) anliegt, entstanden ist.

Im umgeformten Abschnitt 16 des Gehäuses 14 steigt der Abstand zwischen einander gegenüberliegenden Seiten 16a,16b des umgeformten Abschnitts 16 des Gehäuses 14 in Erstreckungsrichtung der bestückten Leiterplatte 11 ausgehend von der den Anschlüssen 12 der bestückten Leiterplatte 11 zugewandten Seite hin zu deren im Gehäuse 14 angeordneten Endabschnitt monoton oder streng monoton. Da auch die Steigung des Abstands zwischen einander gegenüber-liegenden Seiten 16a,16b des umgeformten Abschnitts 16 des Gehäuses 14 in Erstreckungsrichtung der bestückten Leiterplatte 11 ausgehend von der den elektrischen Anschlüssen 12 der bestückten Leiterplatte 11 zugewandten Seite hin zu deren im Gehäuse 14 angeordneten Endabschnitt monoton oder streng monoton verläuft, entsteht ein umgeformter Abschnitt 16, der nach innen, d.h. in Richtung zur bestückten Leiterplatte 11 hin eine Wölbung aufweist und nach außen, d.h. in Richtung von der bestückten Leiterplatte 11 fort, eine konkave Oberflächenkontur aufweist.

Die erfindungsgemäße Ausführungsform einer Sensoranordnung 10, die in Figur 3 gezeigt ist, geht aus dem Zwischenstadium durch Umspritzen mit einem Thermoplast-Material 21 hervor. Der umspritzte Bereich der Sensoranordnung 10 reicht dabei vom umgeformten Abschnitt 16 des Gehäuses 14 bis zum Anschlusskabel 19 und schützt daher die Anschlüsse der Sensoranordnung 10. Dadurch, dass das Thermoplast-Material 21 nach dem Anspritzen aufschrumpft, wird dabei die Dichtwirkung des umgeformten Abschnitts 16 noch verbessert, wobei durch die geometrische Ausgestaltung des umgeformten Abschnitts 16 des Gehäuses 14 darüber hinaus auch noch eine bessere Haftung zwischen Gehäuse 14 und Thermoplast-Material 21 erreicht wird.

### Bezugszeichenliste

- 10: Sensoranordnung
- 11: bestückte Leiterplatte
- 12: elektrischer Anschluss
- 13: Elektronikbauteil
- 14: Gehäuse
- 14a,14b: Stirnseiten des Gehäuses
- 15: Innenraum
- 16: umgeformter Abschnitt
- 16a,16b: einander gegenüberliegende Seiten des umgeformten Abschnitts
- 17: elektrischer Anschluss
- 18: Ader
- 19: Anschlusskabel
- 20: Umformwerkzeug
- 21: Thermoplast-Material

## Patentansprüche

1. Sensoranordnung (10) mit einer bestückten Leiterplatte (11) mit elektrischen Anschlüssen (12), wobei mindestens ein auf der bestückten Leiterplatte (11) angeordnetes Elektronikbauteil (13) oder eine Kombination von auf der bestückten Leiterplatte (11) angeordneten Elektronikbauteilen (13) einen Sensor bilden, und mit einem Gehäuse (14), in dessen Innenraum (15) mindestens ein Endabschnitt der bestückten Leiterplatte (11) angeordnet ist,
**dadurch gekennzeichnet, dass** mindestens ein umgeformter Abschnitt (16) des Gehäuses (14) auf der den elektrischen Anschlüssen (12) der bestückten Leiterplatte (11) zugewandten Seite des Gehäuses (14) vorhanden ist, wobei der umgeformte Abschnitt (16) so umgeformt ist, dass er an der bestückten Leiterplatte (11) dicht anliegt und die Sensoranordnung in einem Bereich vom umgeformten Abschnitt (16) des Gehäuses (14) bis zum Anschlusskabel (19) umspritzt ist.

2. Sensoranordnung (10) nach Anspruch 1,
**dadurch gekennzeichnet, dass** das Gehäuse (14) aus einem thermoplastischen Material besteht.

3. Sensoranordnung (10) nach Anspruch 1 oder 2,
**dadurch gekennzeichnet, dass** im umgeformten Abschnitt (16) des Gehäuses (14) der Abstand zwischen einander gegenüberliegenden Seiten (16a,16b) des umgeformten Abschnitts (16) des Gehäuses (14) in Erstreckungsrichtung der bestückten Leiterplatte (11) ausgehend von der den Anschlüssen (12) der bestückten Leiterplatte (11) zugewandten Seite hin zu deren im Gehäuse (14) angeordneten Endabschnitt monoton oder streng monoton steigt.

4. Sensoranordnung (10) nach Anspruch 3,
**dadurch gekennzeichnet, dass** der umgeformte Abschnitt (16) des Gehäuses (14) einen kegelförmigen Kragen bildet.

5. Sensoranordnung (10) nach Anspruch 3,
**dadurch gekennzeichnet, dass** die Steigung des Abstands zwischen einander gegenüberliegenden Seiten (16a,16b) des umgeformten Abschnitts (16) des Gehäuses (14) in Erstreckungsrichtung der bestückten Leiterplatte (11) ausgehend von der den Anschlüssen (12) der bestückten Leiterplatte (11) zugewandten Seite hin zu deren im Gehäuse (14) angeordneten Endabschnitt monoton oder streng monoton steigt.

6. Sensoranordnung (10) nach einem der vorstehenden Ansprüche,
**dadurch gekennzeichnet, dass** der umgeformte Abschnitt (16) des Gehäuses (14) durch Pressen axial von oben, zwei- oder mehrteilig radial oder in einer Kombination dieser Varianten umgeformt ist.

7. Verfahren zur Herstellung einer Sensoranordnung (10) nach einem der Ansprüche 1 bis 6,
**dadurch gekennzeichnet, dass** der umgeformte Abschnitt (16) des Gehäuses (14) mit einer erwärmten Form umgeformt ist.

## Claims

1. A sensor arrangement (10) having an assembled circuit board (11) with electrical terminals (12), wherein at least one electronic component (13) arranged on the assembled circuit board (11) or a combination of electronic components (13) arranged on the assembled circuit board (11) form a sensor, and having a housing (14) in whose inner space (15) at least one end section of the assembled circuit board (11) is arranged,
**characterized in that** at least one reshaped section (16) of the housing (14) is present on the side of the housing (14) facing the electrical terminals (12) of the assembled circuit board (11), wherein the reshaped section (16) is reshaped such that it contacts the assembled circuit board (11) and the sensor arrangement is overmolded in a region from the reshaped section (16) of the housing (14) up to the terminal cable (19).

2. A sensor arrangement (10) in accordance with claim 1,
**characterized in that** the housing (14) comprises a thermoplastic material.

3. A sensor arrangement (10) in accordance with claim 1 or claim 2,
**characterized in that** the spacing between mutually oppositely disposed sides (16a, 16b) of the reshaped section (16) of the housing (14) increases monotonously or strictly monotonously in the reshaped section (16) of the housing (14) in the direction of extent of the assembled circuit board (11), starting from the side facing the terminals (12) of the assembled circuit board (11) up to its end section arranged in the housing (14).

4. A sensor arrangement (10) in accordance with claim 3,
**characterized in that** the reshaped section (16) of the housing (14) forms a conical collar.

5. A sensor arrangement (10) in accordance with claim 3,
**characterized in that** the pitch of the spacing between mutually oppositely disposed sides (16a, 16b) of the reshaped section (16) of the housing (14) increases monotonously or strictly monotonously in the direction of extent of the assembled circuit board (11), starting from the side facing the terminals (12) of the assembled circuit board (11) up to its end section arranged in the housing (14).

6. A sensor arrangement (10) in accordance with any one of the preceding claims,
**characterized in that** the reshaped section (16) of the housing (14) is reshaped by pressing axially from above, radially in two parts or multiple parts or in a combination of these variants.

7. A method of manufacturing a sensor arrangement (10) in accordance with any one of the claims 1 to 6,
**characterized in that** the reshaped section (16) of the housing (14) is reshaped with a heated mold.

## Revendications

1. Agencement capteur (10) avec une carte à circuits équipée de composants (1), avec des raccords électriques (12), dans lequel au moins un composant électronique (13) agencé sur la carte à circuits équipée (11) ou une combinaison de composants électroniques (13) agencés sur la carte à circuits équipée (11) forme(nt) un capteur, et comprenant un boîtier (14) dans la chambre intérieure duquel (15) est agencée au moins une portion terminale de la carte à circuits équipée (11),
**caractérisé en ce qu'**au moins une portion conformée (16) du boîtier (14) est présente sur le côté du boîtier (14) tourné vers les raccords électriques (12) de la carte à circuits équipée (11), et la portion conformée (16) est conformée de telle manière qu'elle s'applique de façon étanche sur la carte à circuits équipée (11), et l'agencement capteur est enrobé dans une région depuis la portion conformée (16) du boîtier (14) jusqu'au câble de raccordement (19).

2. Agencement capteur (10) selon la revendication 1,
**caractérisé en ce que** le boîtier (14) est en un matériau thermoplastique.

3. Agencement capteur (10) selon la revendication 1 ou 2,
**caractérisé en ce que**, dans la portion conformée (16) du boîtier (14), la distance entre des côtés (16a, 16b) mutuellement opposés de la portion conformée (16) du boîtier (14) augmente, dans la direction d'extension de la carte à circuits équipée (11), en partant du côté tourné vers les raccords (12) de la carte à circuits équipés (11) jusqu'à son tronçon terminal agencé dans le boîtier (14), de manière monotone ou strictement monotone.

4. Agencement capteur (10) selon la revendication 3,
**caractérisé en ce que** la portion conformée (16) du boîtier (14) forme une collerette de forme conique.

5. Agencement capteur (10) selon la revendication 3,
**caractérisé en ce que** le gradient de la distance entre des côtés mutuellement opposés (16a, 16b) de la portion conformée (16) du boîtier (14) dans la direction d'extension de la carte à circuits équipés (11) augmente en partant du côté tourné vers les raccords (12) de la carte à circuits équipée (11) jusqu'à son tronçon terminal agencé dans le boîtier (14), de manière monotone ou strictement monotone.

6. Agencement capteur (10) selon l'une des revendications précédentes,
**caractérisé en ce que** la portion conformée (16) du boîtier (14) est conformée à la presse axialement depuis le haut, radialement en deux ou en plusieurs parties, ou suivant une combinaison de ces variantes.

7. Procédé pour la fabrication d'un agencement capteur (10) selon l'une des revendications 1 à 6,
**caractérisé en ce que** la portion conformée (16) du boîtier (14) est conformée avec un moule chauffé.
